(19) **Europäisches Patentamt**

**European Patent Office**

**Office européen des brevets**

(11) **EP 1 398 644 B1**

(12) **EUROPÄISCHE PATENTSCHRIFT**

(45) Veröffentlichungstag und Bekanntmachung des Hinweises auf die Patenterteilung:
**29.06.2005 Patentblatt 2005/26**

(51) Int Cl.⁷: **G01R 35/02**

(21) Anmeldenummer: **02020424.4**

(22) Anmeldetag: **11.09.2002**

(54) **Verfahren zum Testen eines Transformators und entsprechende Testvorrichtung**

Device and method for testing a transformer

Dispositif et procédé pour tester un transformateur

(84) Benannte Vertragsstaaten:
**DE ES FR GB IT**

(43) Veröffentlichungstag der Anmeldung:
**17.03.2004 Patentblatt 2004/12**

(73) Patentinhaber: **Omicron electronics GmbH
6833 Klaus (AT)**

(72) Erfinder:
- **Süss, Franz
  6805 Feldkirch-Gisingen (AT)**
- **Krüger, Michael, Dr.
  6844 Altach (AT)**
- **Kaufmann, Friedrich
  6800 Feldkirch (AT)**

(74) Vertreter: **Banzer, Hans-Jörg, Dipl.-Ing. et al
Kraus & Weisert
Patent- und Rechtsanwälte
Thomas-Wimmer-Ring 15
80539 München (DE)**

(56) Entgegenhaltungen:
**EP-B- 0 600 726        US-A1- 2001 038 290
US-B1- 6 321 169**

- **"Norm IEC 60044-6" März 1992 (1992-03)
  XP008013013 * Seite 9, Absatz 1 * * Seite 37 -
  Seite 39 * * Abbildung B2 ***

**Beschreibung**

Die vorliegende Erfindung betrifft ein Verfahren sowie eine entsprechend ausgestaltete Testvorrichtung zum Testen eines Transformators. Insbesondere ist die vorliegende Erfindung zum Testen von Messwandlern, vorzugsweise zum Testen von Stromwandlern, geeignet.

Gemäß der Norm IEC 60044-6 sind bei Messwandlern die folgenden Anforderungen zu prüfen:

1. Windungsübersetzungsfehler
2. Übersetzungsfehler und Fehlwinkel im eingeschwungenen Zustand
3. Wicklungswiderstand der Sekundärwicklung
4. Magnetisierungskenngrößen
5. Remanenzfaktor
6. Zeitkonstante des Sekundärkreises
7. Fehler bei Grenzbedingungen
8. Nachweis der Auslegung für niedrigen Streufluss

Bisher auf dem Markt befindliche Testgeräte verwenden einen direkt an das Niederspannungsnetz angeschlossenen verstellbaren Transformator (Variac), welcher als Prüfsignal für den jeweils zu testenden Messwandler ein sinusförmiges Signal mit Netzfrequenz erzeugt. Mit diesen herkömmlichen Geräten können auf der Sekundärseite des Messwandlers Spannungen und Ströme erzeugt werden, welche auch im Nennbetrieb auftreten. Zum Prüfen der meisten gebräuchlichen Messwandler müssen daher diese Testgeräte eine Signalquelle mit einer Scheinleistung von bis zu 5kW aufweisen. Für einige Messwandler werden Spannungen bis 4kV benötigt, andere benötigen Ströme bis 5A. Daher sind die auf dem Markt befindlichen Testgeräte entweder aufgrund ihrer hohen Ausgangsleistung sehr schwer oder sie können nur Messwandler mit kleinen Scheinleistungen prüfen, so dass sie lediglich beschränkt einsetzbar sind.

Es sind zwar Testverfahren bekannt, bei denen zum Testen des jeweiligen Messwandlers Prüfsignale mit reduzierter Prüffrequenz oder Prüfspannung verwendet werden. Diesen Testverfahren ist jedoch gemeinsam, dass sie allesamt sehr ungenau sind, da das geänderte Verhalten von Messwandlern bei einem von der Nenn- bzw. Netzfrequenz abweichenden Betrieb nicht ausreichend berücksichtigt wird.

Dieses Problem betrifft nicht nur den Test von Messwandlern (Strom- oder Spannungswandlern), sondern allgemein den Test von Transformatoren.

Aus der Norm IEC 60044-6, März 1992, ist ein Verfahren zum Testen eines Transformators mit den Merkmalen des Oberbegriffes des unabhängigen Anspruches 1 bzw. 15 bekannt. Dabei wird vorgeschlagen, mit Hilfe eines Prüfsignals mehrere Parameter des Transformators zu messen, um aus den gemessenen Parametern ein Simulationsmodell, welches das Übertragungsverhalten des Transformators bei unterschiedlichen Frequenzen simuliert, abzuleiten, so dass mit Hilfe des Simulationsmodells das Übertragungsverhalten des Transformators bei Betrieb mit einer von der Frequenz des Prüfsignals abweichenden Frequenz ermittelt werden kann. Das Simulationsmodell umfasst dabei insbesondere eine Kennlinie, welche das Verhältnis zwischen dem Spitzenwert des Magnetisierstroms und dem Spitzenwert des magnetischen Flusses bei unterschiedlichen Frequenzen definiert.

Aus der EP 0 600 726 B1 ist darüber hinaus zum Messen der Impedanz eines Energieversorgungssystems, welches auf eine bestimmte Leitungs- oder Nennfrequenz ausgelegt ist, bekannt, mit Hilfe von zwei Prüfsignalen, die in das Energieversorgungssystem eingekoppelt werden und von der Leitungsfrequenz unterschiedliche Frequenzen aufweisen, entsprechende Impedanzwerte des Energieversorgungssystems zu bestimmen, um aus den beiden gemessenen Impedanzwerten die Impedanz des Energieversorgungssystems bei der bestimmten Leitungsfrequenz abzuleiten.

Der vorliegenden Erfindung liegt die Aufgabe zugrunde, ein Verfahren zum Testen eines Transformators, insbesondere eines Messwandlers, vorzugsweise eines Stromwandlers, sowie eine entsprechend ausgestaltete Testvorrichtung bereitzustellen, womit die zuvor beschriebenen Probleme behoben werden können, so dass ein zuverlässiger Test des Transformators auch bei Verwendung einer Signalquelle mit relativ geringer Ausgangsleistung zur Erzeugung des Test- bzw. Prüfsignals gewährleistet ist.

Diese Aufgabe wird erfindungsgemäß durch ein Verfahren zum Testen eines Transformators mit den Merkmalen des Anspruches 1 bzw. einer Testvorrichtung mit den Merkmalen des Anspruches 15 gelöst. Die Unteransprüche definieren jeweils bevorzugte und vorteilhafte Ausführungsformen der vorliegenden Erfindung.

Erfindungsgemäß wird zum Testen eines Transformators, insbesondere eines Messwandlers, vorgeschlagen, zum Messen mehrerer insbesondere frequenzabhängiger Parameter des Transformators ein Prüfsignal an den Transformator anzulegen, dessen Frequenz insbesondere kleiner als die Nenn- oder Betriebsfrequenz des Transformators ist. Aus den mit diesem Prüfsignal gemessenen Parametern wird ein Simulationsmodell abgeleitet, welches eine Simulation des Verhaltens des Transformators bei unterschiedlichen Frequenzen ermöglicht. Mit Hilfe dieses Simulationsmodells bzw. den mit dem Prüfsignal gemessenen Parametern kann dann auf das Verhalten des Transformators bei Betrieb mit einer von der Frequenz des Prüfsignals abweichenden Frequenz, insbesondere auf das Verhalten des Transformators bei Betrieb mit der Nennfrequenz, geschlossen werden.

Das Simulationsmodell, welches mit Hilfe des Prüfsignals ermittelt wird, ist vorzugsweise derart ausgestaltet, dass es frequenz- und/oder spannungsabhängige Parameter des Transformators, insbesondere die Hauptinduktivität, Hystereseverluste, und den Widerstand der Sekundärwicklung des Transformators, berücksichtigt. Hierzu wird jeweils das Prüfsignal sekundärseitig an dem zu testenden Transformator eingespeist und die sich daraufhin einstellenden Parameter des Transformators sekundärseitig gemessen. So ist beispielsweise eine Messung des Widerstands der Sekundärwicklung dadurch möglich, dass als Prüfsignal über die sekundärseitigen Anschlussklemmen des Transformators ein Gleichstrom eingespeist und die daraufhin an den sekundärseitigen Anschlussklemmen abgreifbare Spannung gemessen wird, um daraus den Widerstand der Sekundärwicklung ermitteln zu können.

Die Wirbelstromverluste des Transformators werden erfindungsgemäß durch mehrere Messungen, insbesondere bei identischem magnetischen Fluss, jedoch bei jeweils unterschiedlichen Frequenzen, insbesondere bei zwei unterschiedlichen Frequenzen, gemessen, wobei jeweils anschließend die Verlustleistung aus den Vorzugsweise gemessenen Strom- und Spannungsmomentanwerten an den sekundärseitigen Anschlüssen des Transformators ermittelt wird. Die auf diese Weise gewonnene Verlustleistung kann in die Hystereseverluste und die Wirbelstromverluste des Transformators aufgesplittet werden. Zur Ermittlung der Hytereseverluste des Transformators kann die Magnetisierungs- oder Hysteresekurve des Transformators gemessen werden, wobei hierzu insbesondere ein periodisches Prüfsignal an die sekundärseitigen Anschlussklemmen des Transformators gelegt wird, um aus den sich daraufhin einstellenden Spannungs- und Stromwerten sowie den auf zuvor beschriebene Art und Weise ermittelten Wirbelstromverlusten den Spannungs- und Stromverlauf an der Hauptinduktivität des Transformators zu ermitteln. Durch die Verwendung einer steuerbaren Signalquelle kann in demselben Testlauf automatisch der Wicklungswiderstand und das Strom/Spannungs-Übertragungsverhalten gemessen und die Hysteresekurve für eine beliebige Frequenz und eine beliebige Signalform berechnet werden.

Aus den zuvor beschriebenen Parametern des Transformators wird das Simulationsmodell bestimmt, mit dessen Hilfe der Strom- und Spannungsverlauf an den Anschlussklemmen des Transformators bei einer beliebigen Betriebsfrequenz und bei einer beliebigen Last abgeleitet werden kann. D.h. mit Hilfe des Simulationsmodells kann das Übertragungsverhalten des Messwandlers auch bei höheren Frequenzen oder Oberwellen simuliert werden.

Die vorliegende Erfindung wird bevorzugt zum Testen von Messwandlern, insbesondere von Stromwandlern, eingesetzt. Selbstverständlich ist die vorliegende Erfindung jedoch nicht auf diesen bevorzugten Anwendungsbereich beschränkt, sondern kann allgemein zum Testen beliebiger Transformatoren verwendet werden.

Ein mit der vorliegenden Erfindung verbundener wesentlicher Vorteil besteht darin, dass zum zuverlässigen Testen des jeweiligen Transformators kein Prüfsignal bestimmter Frequenz oder bestimmter Spannung verwendet werden muss. Vielmehr erlaubt die vorliegende Erfindung die Verwendung eines Prüfsignals mit variabler Frequenz und variabler Spannung. Demzufolge erfordert die vorliegende Erfindung auch nicht die Verwendung einer leistungsfähigen Sinusspannungsquelle mit hoher Ausgangsleistung zur Generierung des Prüfsignals, sondern es kann auch mit einer Signalquelle niedriger Leistung, insbesondere mit einer sehr schwachen Signalquelle, praktisch jeder Transformator oder Messwandler getestet werden. Der Test erfolgt nicht mit der Nennfrequenz des Transformators, sondern vorzugsweise mit einem Prüfsignal, dessen Frequenz kleiner als die Nennfrequenz des Transformators ist. Zudem ist die Spannung des Prüfsignals vorzugsweise deutlich geringer als die Prüfspannung herkömmlicher Testgeräte. So kann insbesondere ein Prüfsignal verwendet werden, dessen Spannung wesentlich kleiner als derjenige Spannungswert ist, welcher zum Messen des so genannten Kniepunktes des Transformators bei der Nennfrequenz des Transformators nötig wäre. Das Prüfsignal ist dabei insbesondere derart beschaffen, dass es im Magnetkern des Transformators denselben magnetischen Fluss wie ein Prüfsignal bei der Nennfrequenz des Transformators bewirkt.

Mit Hilfe der vorliegenden Erfindung können somit alle existierenden Transformatoren oder Messwandler zuverlässig getestet werden. Durch die hierin vorgeschlagenen Messungen und dadurch bekannten Modellparameter können eine Vielzahl von unterschiedlichen Größen gemessen werden, wobei u.a. insbesondere eine Messung oder Berechnung des Windungsübersetzungsfehlers ("Ratio Error"), des Übersetzungsfehlers und Fehlerwinkels im eingeschwungenen Zustand ("Phase Displacement"), der Gesamtmessabweichung ("Composite Error"), des Remanenzfaktors ("Remanence Factor") und des Fehlers bei Grenzbedingungen ("Error at Limiting Conditions") möglich ist.

Das erfindungsgemäße Testgerät kann aufgrund seiner sehr geringen Ausgangsleistung sehr leicht, und insbesondere in Form eines tragbaren Geräts, ausgestaltet werden. Da nur wenig Ausgangsleistung aufgebracht werden muss und zudem ein Test des jeweiligen Transformators auch mit einem nicht-sinusförmigen Prüfsignal möglich ist, sind die mit dem Testgerät verbundenen Herstellungskosten ebenfalls sehr gering. Ein Rechteck-Prüfsignal ist grundsätzlich billiger zu generieren als ein Sinus-Prüfsignal. Der Test des jeweiligen Transformators erfolgt vorzugsweise automatisiert, so dass reproduzierbare Testergebnisse erzielt werden können. Da mit dem gemessenen Simulationsmodell des Transformators gearbeitet wird, kann das Verhalten des Transformators bei unterschiedlicher Belastung simuliert werden, ohne dass hierzu eine Hochleistungssignalquelle erforderlich wäre. Durch das Rückrechnen der somit gewonnen Messergebnisse auf die Nennfrequenz des Transformators erhält die Bedienperson das tatsächlich bei der Anwendung auftretende Verhalten des Transformators, da in den Messergebnissen die tatsächlich an dem Transformator auftretenden Spannungen und Ströme dargestellt werden.

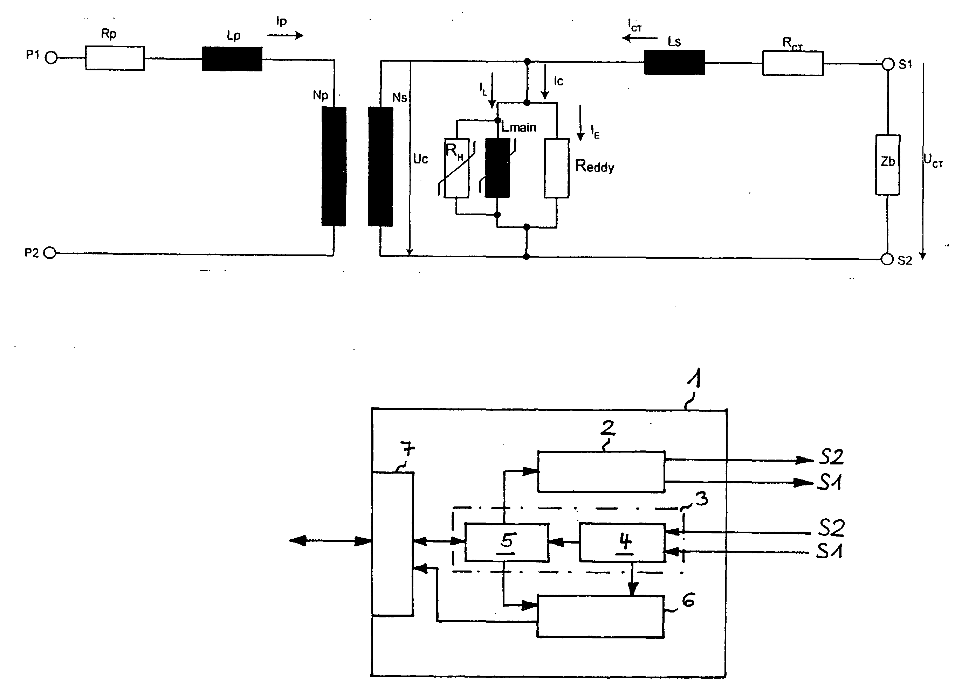

Die vorliegende Erfindung wird nachfolgend unter Bezugnahme auf die beigefügte Zeichnung anhand eines bevorzugten Ausführungsbeispiels näher erläutert.

In der einzigen Figur ist ein Ersatzschaltbild eines zu testenden Transformators oder Messwandlers und eine bevorzugte Ausführungsform eines erfindungsgemäßen Testgerätes dargestellt.

Dabei bezeichnen P1, P2 primärseitige Anschlussklemmen und S1, S2 sekundärseitige Anschlussklemmen des Messwandlers. Np und Ns bezeichnen die primäre bzw. sekundäre Windungszahl des (idealen) Messwandlers, während Rp und Lp den Widerstand bzw. die Streuinduktivität der Primärwicklung und $R_{CT}$ und Ls den Widerstand bzw. die Streuinduktivität der Sekundärwicklung des Messwandlers bezeichnen. $R_H$ entspricht den Hystereseverlusten des Messwandlers, während Reddy den Wirbelstromwiderstand des Messwandlers zur Modellierung der Wirbelstromverluste darstellt. Lmain bezeichnet die Hauptinduktivität des Messwandlers. Die Hauptinduktivität Lmain und die Hystereseverluste RH des Messwandlers werden - wie nachfolgend noch näher erläutert wird - mit der Hystereseschleife des Messwandlers modelliert. Mit Zb ist die Impendanz der Last oder Bürde des Messwandlers bei Nennfrequenz bezeichnet. Ip bezeichnet den über die primärseitigen Anschlussklemmen fließenden Strom, und $I_{CT}$ bezeichnet den über die sekundärseitigen Anschlussklemmen fließenden Strom. Die Spannung an den sekundärseitigen Anschlussklemmen ist mit $U_{CT}$ bezeichnet. Uc gibt die an der Hauptinduktivität des Messwandlers anliegende Spannung an, wobei der über die Parallelschaltung aus $R_H$, Lmain und Reddy fließende Strom mit Ic bezeichnet ist, welcher sich gemäß der Figur in einen über den Wirbelstromwiderstand Reddy fließenden Strom $I_E$ und einen über die Parallelschaltung aus $R_H$ und Lmain fließenden Strom $I_L$ aufteilt.

Im Folgenden sind bei der Angabe von Spannungen und Strömen immer die entsprechenden momentanen Werte gemeint, sofern nicht durch den Index "eff" ausdrücklich auf den Effektivwert verwiesen wird.

Es ist bekannt, dass der so genannte verkettete Fluss ψ von der Spannungszeitfläche, das heißt dem Spannungsintegral über die Zeit, an den sekundärseitigen Anschlussklemmen des Messwandlers abhängt. Demzufolge gilt mit $\psi_0$ als Konstante:

$$(1) \qquad \psi(t) = \int_0^t [U_{CT}(t) - R_{CT} \cdot I_{CT}(t)]\,dt + \psi_0$$

Wird für den Test des Messwandlers lediglich ein Prüfsignal mit relativ niedriger Frequenz verwendet, entstehen je nach Wandlertyp mehr oder weniger große Messfehler durch das bei der niedrigen Prüffrequenz abweichende Verhalten des Magnet- oder Eisenkerns des Messwandlers. Demzufolge ist ohne Berücksichtigung des frequenzabhängigen Verhaltens des Eisenkerns bei einem Test des Messwandlers mit niedriger Prüffrequenz nur ein sehr ungenaues Verhalten bei der Nennfrequenz des Messwandlers vorherzusagen. Um genaue Messergebnisse zu erhalten, wird daher ein Simulationsmodell des zu testenden Messwandlers definiert, welches es erlaubt, das frequenzabhängige Verhalten des Messwandlers mit Hilfe von wenigen Parametern zu beschreiben. Dieses Simulationsmodell wird so einfach wie möglich gehalten, damit einerseits keine aufwändigen Messungen für die Bestimmung dieser Parameter nötig sind und andererseits die anschließenden Berechnungen für einen Rückschluss des Verhaltens des Messwandlers bei einem Betrieb mit der Nennfrequenz wenig Zeit benötigen.

Für den Test des Messwandlers spielen der Widerstand Rp der Primärwicklung und die primäre Streuinduktivität Lp keine Rolle und müssen daher auch nicht gemessen werden. Die sekundäre Streuinduktivität Ls kann lediglich relativ aufwändig bestimmt werden. Da sie jedoch im Allgemeinen für das abschließende Messergebnis lediglich eine untergeordnete Rolle spielt, wird sie nachfolgend ebenfalls vernachlässigt.

Das in der einzigen Figur dargestellte Ersatzschaltbild eines Messwandlers entspricht weitgehend einem konventionellen Ersatzschaltbild. Wie jedoch bereits zuvor erwähnt worden ist, wird im Gegensatz zu dem konventionellen Ersatzschaltbild die Hauptinduktivität Lmain nicht einfach als lineare Induktivität mit Eisenverlustwiderstand, sondern als nichtlineare Induktivität angenommen, welche für periodische Signale mit Hilfe einer (frequenzabhängigen) Hysteresekurve beschrieben wird. Der Eisenkern des Messwandlers wird daher mit Hilfe der nichtlinearen Hauptinduktivität Lmain, welche das nicht-lineare Verhalten des Eisenkerns ohne Hystereseverhalten (das heißt verlustlos) beschreibt, dem Hystereseverlustwiderstand $R_H$, welcher die Hystereseverluste beschreibt und ebenfalls nichtlinear ist, und dem linearen Wirbelstromwiderstand Reddy, welcher die Wirbelstromverluste im Eisenkern berücksichtigt, modelliert. Die nicht-lineare Hauptinduktivität Lmain und der Hystereseverlustwiderstand $R_H$ werden zusammen mit Hilfe einer frequenzunabhängigen Hysteresekurve beschrieben. Diese Hysteresekurve wird in Bezug auf die Zeit periodisch durchlaufen, wobei jedoch die Form nicht von der Geschwindigkeit des Durchlaufens abhängt und somit auch unabhängig von der zeitlichen Kurvenform der Messgrößen ist. Die Hysteresekurve hängt jedoch von der Aussteuerung des Messwandlers ab und ist je nach Signalamplitude unterschiedlich geformt. Als Parameter diesbezüglich dient der maximale verkettete Fluss $\psi_{max}$.

Die Wicklungswiderstände Rp und Rs sowie die Streuinduktivitäten Lp und Ls werden in dem in der Figur dargestellten Ersatzschaltbild wie bei dem konventionellen oder klassischen Ersatzschaltbild eines Transformators beschrieben.

Neben dem Ersatzschaltbild des zu testenden Messwandlers ist in der Figur auch ein bevorzugtes Ausführungsbeispiel eines erfindungsgemäßen Testgeräts 1, welches insbesondere in Form eines tragbaren Testgeräts ausgestaltet ist, dargestellt.

Das Testgerät 1 umfasst als wesentliche Komponenten eine steuerbare Signalquelle 2, eine Steuereinheit 3 mit einer Messeinrichtung 4 und einer Auswertungs- und Steuereinrichtung 5, einen Speicher 6 zum Speichern von Messergebnissen und eine Schnittstelle 7 zur vorzugsweise bidirektionalen Kommunikation mit einem externen Gerät, beispielsweise einem externen Computer, um von diesem externen Gerät Steuersignale zur automatischen Steuerung des von dem Testgerät 1 durchgeführten Testablaufs zu empfangen oder Test- oder Messergebnisse an dieses externe Gerät zu übertragen. Die Steuereinheit 3, welche auch die Funktion einer Datenverarbeitungseinheit wahrnimmt, kann in Form eines Controllers und/oder Computers und/oder digitalen Signalprozessors ausgestaltet sein. Die Steuereinheit 3 erzeugt abhängig von einem vorgegebenen Testablauf über die Steuer- und Auswertungseinrichtung 5 Steuersignale für die steuerbare Signalquelle 2, um ein Prüfsignal vorgegebener Frequenz und/oder Spannung an die sekundärseitigen Anschlussklemmen S1, S2 des zu testenden Messwandlers anzulegen. Des Weiteren weist das Testgerät mehrere Messeingänge auf, von denen in der Figur lediglich ein Messeingang beispielhaft dargestellt ist, um über die sekundärseitigen Anschlussklemmen S1, S2 des Messwandlers abgegriffene Messsignale der Messeinrichtung 4 der Steuereinheit 3 zuzuführen, um somit verschiedene frequenz- und vorzugsweise auch spannungsabhängige Parameter des zu testenden Messwandlers zu bestimmen, welche anschließend von der Steuer- und Auswertungseinrichtung 5 ausgewertet werden, um daraus das bereits erwähne Simulationsmodell abzuleiten, welches der Steuer- und Auswertungseinrichtung Rückschlüsse auf das tatsächliche Verhalten des zu testenden Messwandlers bei beliebigen Frequenzen und Lasten Zb, insbesondere auch bei der eigentlich vorgesehenen Nenn- oder Betriebsfrequenz des Messwandlers, ermöglicht. Die von der Messeinrichtung 4 erfassten Messergebnisse und/oder das von der Steuer- und Auswertungseinrichtung 5 daraus abgeleitete Simulationsmodell können in dem Speicher 6 für einen späteren Zugriff zwischengespeichert werden. Auf diese Weise können die Mess- und Testergebnisse auch in Form eines Testberichts archiviert und protokolliert und über eine (in der Zeichnung nicht dargestelle) Ausgabeeinheit, beispielsweise einen Bildschirm oder einen Drucker, ausgegeben werden. Die Steuereinheit 3 (bzw. die darin enthaltene Steuer- und Auswertungseinrichtung 5) steuert den von dem Testgerät 1 durchgeführten Test- oder Prüfablauf des Messwandlers vollautomatisch, das heißt über die steuerbare Signalquelle 2 werden zum Messen der unterschiedlichen Parameter des Messwandlers, welche die Grundlage für das Simulationsmodell bilden, automatisch verschiedene Prüfsignale sekundärseitig an den zu testenden Messwandler angelegt, ohne dass ein zwischenzeitlicher Eingriff einer Bedienperson erforderlich wäre. Der Testablauf kann dabei in Übereinstimmung mit einem gespeicherten Programmcode (Software) erfolgen. Ebenso ist auch denkbar, dass - wie bereits zuvor erwähnt worden ist - die Steuerung des Testablaufs über die Schnittstelle 7 mit Hilfe eines externen Geräts erfolgt. Bei der steuerbaren Signalquelle 2 handelt es sich vorzugsweise um eine auf einen vorgegebenen Wert geregelte Signalquelle, welche somit von Netzschwankungen unabhängig ist.

Einer der Parameter des Messwandlers, welche von der Messeinrichtung 4 des Testgeräts 1 zur nachfolgenden Ermittlung des Simulationsmodells des Messwandlers erfasst werden, ist der Widerstand $R_{CT}$ der Sekundärwicklung des Messwandlers. Zu diesem Zweck wird die steuerbare Signalquelle 2 derart angesteuert, dass von ihr ein Gleichstrom an die sekundärseitigen Anschlussklemmen S1, S2 angelegt wird. Die Messeinrichtung 4 kann daraufhin den Widerstand $R_{CT}$ des Messwandlers durch Erfassen des Stroms und der Spannung an den sekundärseitigen Anschlussklemmen messen. Der Widerstand $R_{CT}$ der Sekundärwicklung bei einem Betrieb des Messwandlers mit der Nennfrequenz unterscheidet sich aufgrund des Skin-Effekts und des Proximity-Effekts (Stromverdrängung) prinzipiell von dem gemessenen Widerstandswert, welcher sich bei sekundärseitigem Betrieb des Messwandlers mit Gleichstrom bzw. Gleichspannung einstellt. Diese Unterschiede sind jedoch im Allgemeinen so gering, dass diese Effekte vernachlässigt werden können.

Da für den Test des Messwandlers die Modellierung des Eisenkerns des Messwandlers von besonderer Bedeutung ist, ist diesbezüglich auf eine möglichst exakte Modellierung zu achten. Das Verhalten des Eisenkerns des Messwandlers kann mit Hilfe der Hysteresekurve beschrieben werden, welche das Verhalten zwischen der magnetischen Anregung H und der magnetischen Flussdichte B angibt, wenn der Eisenkern mit einem periodischen Signal angeregt wird. Dabei zeigt sich, dass die Form der Hysteresekurve von der Frequenz der periodischen Anregung abhängt. Der Grund hierfür sind vor allem die Wirbelströme im Eisenkern. Aufgrund der sich ändernden magnetischen Flussdichte entstehen im Eisenkern elektrische Wirbelfelder (Induktionsgesetz), welche aufgrund der Leitfähigkeit des Eisens Wirbelströme erzeugen. Die von der Sekundärwicklung des Messwandlers hervorgerufene Wirkung ist gleichwertig zu einer zusätzlichen Wicklung auf dem Eisenkern, welche mit einem Widerstand belastet wird. Somit können - wie auch in der Figur angedeutet ist - die Wirbelstromverluste mit einem linearen Widerstand Reddy modelliert werden. Für die Bestimmung dieses Widerstands Reddy sind zunächst die Hystereseverluste und die Wirbelstromverluste zu trennen.

Im Eisenkern können nur die gesamten Verluste gemessen werden. Hierzu wird die Signalquelle 2 derart angesteuert, dass an die Sekundärwicklung des Messwandlers eine periodische Spannung angelegt und die von dem Messwandler aufgenommene Leistung ermittelt wird, wenn die Primärseite des Messwandlers offen betrieben wird. Ein Teil der von dem Messwandler aufgenommenen Leistung geht in der Sekundärwicklung des Messwandlers verloren, die restliche Leistung im Eisenkern. Das für diese Messung von der Signalquelle 2 erzeugte Prüfsignal kann insbesondere ein nicht-sinusförmiges Prüfsignal, beispielsweise ein Rechteck-Signal, sein, so dass die Signalquelle 2 beispielsweise auch auf besonders billige Art und Weise als wechselweise gepolte Spannungsquelle ausgestaltet sein kann.

Die Aufteilung in Hystereseverluste und Wirbelstromverluste erfolgt aufgrund des unterschiedlichen Verhaltens im Bezug auf die Anregungsfrequenz, wobei eine gleiche maximale Flussdichte vorausgesetzt wird.

Die Hystereseverluste steigen proportional zur Frequenz an, während die Wirbelstromverluste quadratisch mit der Frequenz ansteigen. Die Gesamtverlustleistung $P_T$, die Hysterese-Verlustleistung $P_H$ und die Wirbelstrom-Verlustleistung $P_E$ ("Eddy Losses") lassen sich somit in Abhängigkeit von der Frequenz wie folgt beschreiben:

$$(2) \qquad P_T(f) = P_H + P_E$$

$$P_H(f) = \alpha \cdot f$$

$$P_E(f) = \beta \cdot f^2$$

Mit zwei Messungen bei verschiedenen Anregungsfrequenzen kann eine Trennung der Hystereseverluste und der Wirbelstromverluste erreicht werden. Da zwei Messungen mit unterschiedlicher Frequenz bei einer identischen maximalen Flussdichte durchgeführt werden, können die bei den beiden Frequenzen $f_1$ und $f_2$ gemessenen Eisenverluste $P_1$ und $P_2$ in Abhängigkeit von den Faktoren $\alpha$ und $\beta$ wie folgt berechnet werden:

$$(3) \qquad P_1 = \alpha \cdot f_1 + \beta \cdot f_1^2$$

$$P_2 = \alpha \cdot f_2 + \beta \cdot f_2^2$$

Die Faktoren $\alpha$ und $\beta$ lassen sich somit folgendermaßen bestimmen:

$$(4) \qquad \alpha = \frac{P_1 \cdot f_2^2 - P_2 \cdot f_1^2}{f_1 \cdot f_2 \cdot (f_2 - f_1)}$$

$$\beta = \frac{P_2 \cdot f_1 - P_1 \cdot f_2}{f_1 \cdot f_2 \cdot (f_2 - f_1)}$$

Der Wirbelstromwiderstand Reddy kann dann in Abhängigkeit von den Anregungsfrequenzen $f_1$ und $f_2$, dem nunmehr bekannten Faktor $\beta$ und den Effektivwerten $Uc_{eff1}$ $Uc_{eff2}$ der Spannung Uc bei den beiden Messungen mit den Frequenzen $f_1$ und $f_2$ folgendermaßen berechnet werden:

$$(5) \qquad \text{Reddy} = \frac{Uc_{eff1}^2}{\beta \cdot f_1^2} = \frac{Uc_{eff2}^2}{\beta \cdot f_2^2}$$

Unter der Annahme des gleichen maximalen Flusses im Eisenkern nehmen die Wirbelstromverluste zunächst mit $f^2$ zu, bei höheren Frequenzen jedoch nur noch mit $f^{1,5}$. Der Übergang von der ersten Gesetzmäßigkeit zu der zweiten Gesetzmäßigkeit hängt von der Leitfähigkeit des Materials, der magnetischen Permeabilität und der Blechstärke (Dicke) der Eisenbleche des Messwandlers ab. Die Blechstärke des Eisenkerns ist immer so dimensioniert, dass nur eine geringe Flussverdrängung bei der Nennfrequenz des Messwandlers auftritt, um die Verluste klein zu halten. Somit ist die Grenze zwischen den beiden Gesetzmäßigkeiten bei einer Frequenz, welche deutlich über der Nennfrequenz des Messwandlers liegt. Bei den hier durchgeführten Messungen kann daher mit guter Genauigkeit von einer quadratischen Abhängigkeit der Wirbelstromverluste von der Frequenz ausgegangen werden.

Als weiterer Parameter des zu testenden Messwandlers wird die Hysteresekurve des Messwandlers gemessen. Mit der Hysteresekurve werden die Hystereseverluste $R_H$ und die Hauptinduktivität Lmain des Messwandlers modelliert.

Für die Messung der Hysteresekurve wird die Signalquelle 2 von der Steuereinheit 3 bzw. der darin enthaltenen Steuer- und Auswertungseinrichtung 5 derart angesteuert, dass ein periodisches, gegebenenfalls wiederum nicht-sinusförmiges Prüfsignal an die sekundärseitigen Anschlussklemmen S1, S2 des Messwandlers angelegt wird. Die Messeinrichtung 4 misst die daraufhin an den sekundärseitigen Anschlussklemmen auftretenden Strom- und Spannungswerte, sodass die Steuer- und Auswertungseinrichtung 5 aus den von der Messeinrichtung 4 gemessenen Strom- und Spannungswerten sowie dem vorher ermittelten Wirbelstromwiderstand auf den Spannungs- und Stromverlauf, das heißt auf die Größen Uc und $I_L$, an der Hauptinduktivität des Messwandlers schließen kann. Das von der Signalquelle 2 erzeugte Prüfsignal besitzt vorzugsweise eine Frequenz, welche unterschiedlich von der Nennfrequenz des Messwandlers, insbesondere deutlich geringer ist.

Bei Vernachlässigung der Streuinduktivität des Messwandlers kann die Spannung Uc und der Strom $I_L$ an der Hauptinduktivität aus den von der Messeinrichtung 4 gemessenen Strom- und Spannungswerten $U_{CT}$ und $I_{CT}$ an den sekundärseitigen Anschlussklemmen des Messwandlers sowie dem zuvor ermittelten Wirbelstromwiderstand Reddy folgendermaßen ermittelt werden:

$$(6) \qquad Uc = U_{CT} - R_{CT} \cdot I_{CT}$$

$$I_L = I_{CT} - \frac{Uc}{\text{Re}ddy}$$

Aus dem zeitabhängigen Spannungsverlauf Uc(t) kann der verkettete Fluss $\psi(t)$ in Übereinstimmung mit der obigen Formel (1) berechnet werden. Die Konstante $\psi_0$ wird so bestimmt, dass der Mittelwert des verketteten Flusses 0 ist, so dass eine Offset-Korrektur gegeben ist.

Der Zusammenhang zwischen dem Strom $I_L(t)$ und dem verketteten Fluss $\psi(t)$ wird als Hysteresekurve bezeichnet und ist eine Parameterdarstellung zwischen dem Strom $I_L(t)$, welcher proportional zur magnetischen Anregung H ist, und dem verketteten Fluss $\psi(t)$, welcher proportional zur magnetischen Flussdichte B ist, wobei die Zeit t der Parameter dieser Funktionsdarstellung ist. Da die Wirbelstromverluste bereits beim Strom $I_L(t)$ berücksichtigt worden sind, ist diese Hysteresekurve weitgehend unabhängig von der Frequenz.

Die auf diese Weise gewonnene Parameterdarstellung kann in eine zeitunabhängige Parameterdarstellung umgeformt werden, wenn ein zeitunabhängiger Parameter p eingeführt wird:

$$(7) \qquad \psi_H(p) = \psi(t)$$

$$I_H(p) = I_L(t)$$

$$p = \frac{t}{T}$$

Dabei bezeichnet T die Periodendauer bei der Messung der Hysteresekurve, während $\psi_H$ den von dem zeitunabhängigen Parameter p, welcher im Intervall [0,1] liegt, abhängigen magnetischen Fluss und $I_H$ den von dem zeitunabhängigen Parameter p abhängigen Strom über die Hauptinduktivität des Messwandlers bezeichnet.

Mit Hilfe der obigen Parameterdarstellung kann das Verhalten des Eisenkerns für einen bestimmten maximalen verketteten Fluss $\psi_{max}$ bestimmt werden, wobei das Verhalten unabhängig vom zeitlichen Verlauf des Prüfsignals ist. Es wird lediglich vorausgesetzt, dass der Eisenkern mit Hilfe des Prüfsignals periodisch angeregt und derselbe maximale verkettete Fluss $\psi_{max}$ erreicht wird.

Soll das Verhalten des Messwandlers bei verschiedenen Aussteuerungen ermittelt werden, so ist für jede Aussteuerung jeweils eine eigene Hysteresekurve zu ermitteln, und genau für diese Aussteuerung gilt dann das ermittelte mathematische Simulaetionsmodell. Somit wird im Prinzip für eine vollständige Beschreibung des Messwandlers eine Schar von Hysteresekurven benötigt, wobei jede Hysteresekurve mit dem maximalen verketteten Fluss charakterisiert werden kann.

Mit Hilfe der auf zuvor beschriebene Art und Weise von der Messeinrichtung 4 des Testgeräts 1 gemessenen Messgrößen des zu testenden Messwandlers kann ein mathematisches Simulationsmodell des Messwandlers gebildet werden, dessen Parameter die gemessenen Messgrößen sind. Mit Hilfe dieses Simulationsmodells kann das Verhalten des Messwandlers bei unterschiedlicher Belastung und insbesondere bei einer von der Frequenz des Prüfsignals abweichenden Betriebsfrequenz und auch bei einem Betrieb des Messwandlers mit einer Spannung mit einer anderen Kurvenform als das Prüfsignal ermittelt werden.

Grundsätzlich ist es möglich, den Verlauf des verketteten Flusses im Eisenkern des Messwandlers exakt zu bestimmen, wenn eine sinusförmige Spannung an den Klemmen des Messwandlers (z.B. mit harmonischer Balance) vorgegeben wird. Der hierzu notwendige Rechenaufwand ist jedoch relativ hoch, so dass ein vereinfachtes Verfahren angestrebt wird, welches nachfolgend beschrieben werden soll.

Als Ansatzpunkt für dieses vereinfachte Verfahren dient ein sinus- bzw. cosinusförmiger Verlauf des verketteten Flusses bei der Nennfrequenz $f_N$ des Messwandlers:

$$(8) \qquad \psi(t) = -\psi_{max} \cdot \cos(2\pi f_N t)$$

Damit erhält man eine induzierte Spannung Uc in der Sekundärwicklung des Messwandlers in Abhängigkeit von der Nennfrequenz $f_N$ und dem maximalen verketteten Fluss $\psi_{max}$ wie folgt:

$$(9) \qquad Uc = 2\pi f_N \cdot \psi_{max} \cdot \sin(2\pi f_N t)$$

Somit kann für jeden Zeitpunkt t der verkettete Fluss $\psi(t)$ angegeben und anhand der Parameterdarstellung der Hysteresekurve der zeitunabhängige Parameter p genau für diesen Zeitpunkt t ermittelt werden, um daraus den Strom $I_L(t)$ für diesen Zeitpunkt zu bestimmen (vgl. die obigen Formeln (1) und (7)). Der zeitliche Verlauf des Stromes $I_L(t)$ kann somit genau angegeben werden.

Mit Hilfe der Kirchhoff'schen Regeln kann auf Grundlage der nunmehr bekannten Größen $I_L$, Uc und Reddy der sekundäre Klemmenstrom $I_{CT}$ und die sekundäre Klemmenspannung $U_{CT}$ des Messwandlers wie folgt bestimmt werden:

$$(10) \qquad I_{CT} = I_L + \frac{Uc}{\mathrm{Re}dy}$$

$$U_{CT} = Uc + I_{CT} \cdot R_{CT}$$

Der zeitliche Verlauf der Klemmenspannung $U_{CT}(t)$ ist nicht mehr exakt sinusförmig, da der Strom starke Verzerrungen aufweist und am Widerstand $R_{CT}$ eine dazu proportionale Spannung abfällt. Die Abweichung von der Sinusform ist im Allgemeinen sehr gering, da der Wicklungswiderstand des Messwandlers im Allgemeinen sehr klein ist.

Üblicherweise wird bei der von der Anmelderin als "CT-Excitation Curve" bezeichneten Art der Testdarstellung der Zusammenhang des Effektivwerts des Stroms $I_{CT}$ und der Spannung $U_{CT}$ an der Sekundärseite des Messwandlers bei offener primärer Wicklung dargestellt. Für den Fall, dass die Spannung $U_{CT}$ keinen sinusförmigen Verlauf aufweist, kann anstelle des Effektivwerts ein korrigierter Gleichrichtwert verwendet werden, wobei als Korrekturfaktor der Sinus-Formfaktor dient:

$$(11) \qquad U_{CT}^{'} = \frac{\pi}{T\sqrt{8}} \int_0^T \left| U_{CT}(t) \right| dt$$

$$I_{CT}^{'} = \sqrt{\frac{1}{T}\int_0^T I_{CT}^2(t)\, dt} \qquad \text{(Darstellung des Stromes als Effektivwert gemäß Norm IEC 60044-1)}$$

$$I'_{CT} = \max \left| I_{CT}(t) \right| \qquad \text{(Darstellung des Stromes als Spitzenwert gemäß Norm IEC 60044-6)}$$

$U_{CT}'$ bzw. $I_{CT}'$ bezeichnen den jeweils korrigierten Wert der sekundärseitigen Klemmenspannung bzw. des sekundärseitigen Klemmenstroms. Durch die zuvor beschriebene Maßnahme kann im Wesentlichen unabhängig von der Kurvenform derselbe maximale Fluss erreicht werden.

Damit kann jeweils ein Punkt dieser Anregungskurve ("CT-Excitation Curve", CT = "Current Transformer") aus jeweils einer Hysteresekurve erhalten werden. Für die gesamte Anregungskurve ist eine entsprechend große Anzahl von Hysteresekurven zu ermitteln.

Abschließend soll darauf hingewiesen werden, dass die oben angeführten Berechnungsmethoden lediglich beispielhaft zu verstehen sind, wobei insbesondere auch eine Verfeinerung dieser Berechnungsmethoden möglich ist.

**Patentansprüche**

1. Verfahren zum Testen eines Transformators,
   wobei zum Testen des Transformators an den Transformator ein Prüfsignal mit einer bestimmten Frequenz angelegt wird,
   wobei mit dem Prüfsignal mehrere Parameter des Transformators gemessen werden,
   wobei aus den mit dem Prüfsignal gemessenen Parametern ein Simulationsmodell, welches das Übertragungsverhalten des Transformators bei unterschiedlichen Frequenzen simuliert, abgeleitet wird, und
   wobei mit Hilfe des Simulationsmodells das Übertragungsverhalten des Transformators bei Betrieb mit einer von der Frequenz des Prüfsignals abweichenden Frequenz ermittelt wird,
   **dadurch gekennzeichnet,**
   **dass** als einer der Parameter des Transformators der Wirbelstromwiderstand (Reddy) des Transformators gemessen wird, wobei hierzu mehrere Messungen durch Anlegen eines periodischen Prüfsignals mit jeweils unterschiedlicher Frequenz an sekundärseitige Anschlüsse (S1, S2) des Transformators durchgeführt werden, und wobei die bei den einzelnen Messungen von dem Transformator sekundärseitig aufgenommene Leistung ermittelt wird, um daraus den Wirbelstromwiderstand (Reddy) abzuleiten.

2. Verfahren nach Anspruch 1,
   **dadurch gekennzeichnet,**
   **dass** die Frequenz des Prüfsignals kleiner als die Nennfrequenz des Transformators ist, und
   **dass** mit Hilfe des Simulationsmodells das Übertragungsverhalten des Transformators bei Betrieb mit der Nennfrequenz ermittelt wird.

3. Verfahren nach Anspruch 1 oder 2,
   **dadurch gekennzeichnet,**
   **dass** das Prüfsignal an sekundärseitige Anschlüsse (S1, S2) des Transformators angelegt wird, und
   **dass** die Parameter des Transformators an den sekundärseitigen Anschlüssen (S1, S2) des Transformators gemessen werden.

4. Verfahren nach einem der vorhergehenden Ansprüche,
   **dadurch gekennzeichnet,**
   **dass** das Prüfsignal mit einer Spannung an den Transformator angelegt wird, welche kleiner als die bei einem Betrieb des Transformators mit der Nennfrequenz zur Messung des Kniepunkts erforderliche Spannung ist.

5. Verfahren nach einem der vorhergehenden Ansprüche,
   **dadurch gekennzeichnet,**
   **dass** mit dem Prüfsignal mehrere frequenz- und/oder spannungsabhängige Parameter des Transformators gemessen werden, um daraus das Simulationsmodell abzuleiten.

6. Verfahren nach einem der vorhergehenden Ansprüche,
   **dadurch gekennzeichnet,**
   **dass** als einer der Parameter der Widerstand ($R_{CT}$) der Sekundärwicklung des Transformators gemessen wird, wobei hierzu als Prüfsignal ein Gleichstromsignal an sekundärseitige Anschlüsse (S1, S2) des Transformators angelegt und die an den sekundärseitigen Anschlüssen (S1, S2) des Transformators auftretende Spannung ($U_{CT}$) und der über die sekundärseitigen Anschlüsse (S1, S2) des Transformators fließende Strom ($I_{CT}$) gemessen werden, um daraus den Widerstand ($R_{CT}$) der Sekundärwicklung abzuleiten.

7. Verfahren nach einem der vorhergehenden Ansprüche,
   **dadurch gekennzeichnet,**
   **dass** zur Messung des Wirbelstromwiderstands (Reddy) des Transformators zwei Messungen bei zwei verschiedenen Frequenzen $f_1$ und $f_2$ durchgeführt und die bei den beiden Messungen von dem Transformator aufgenommene Leistung $P_1$ und $P_2$ gemessen wird,

wobei gilt:

$$P_1 = \alpha \cdot f_1 + \beta \cdot f_1^2$$

$$P_2 = \alpha \cdot f_2 + \beta \cdot f_2^2,$$

wobei die Faktoren $\alpha$ und $\beta$ in Abhängigkeit von den Frequenzen $f_1$ und $f_2$ sowie den Leistungen $P_1$ und $P_2$ wie folgt bestimmt werden:

$$\alpha = \frac{P_1 \cdot f_2^2 - P_2 \cdot f_1^2}{f_1 \cdot f_2 \cdot (f_2 - f_1)}$$

$$\beta = \frac{P_2 \cdot f_1 - P_1 \cdot f_2}{f_1 \cdot f_2 \cdot (f_2 - f_1)},$$

um daraus den Wirbelstromwiderstand (Reddy) abzuleiten.

8. Verfahren nach Anspruch 7,
   **dadurch gekennzeichnet,**
   **dass** der Wirbelstromwiderstand Reddy über folgende Beziehung bestimmt wird:

$$\text{Reddy} = \frac{Uc_{eff1}^2}{\beta \cdot f_1^2} = \frac{Uc_{eff2}^2}{\beta \cdot f_2^2},$$

wobei $UC_{eff1}$ den Effektivwert der Spannung an der Hauptinduktivität des Transformators bei der Messung mit der Frequenz $f_1$ und $Uc_{eff2}$ den Effektivwert der Spannung an der Hauptinduktivität des Transformators bei der Messung mit der Frequenz $f_2$ bezeichnet.

9. Verfahren nach einem der vorhergehenden Ansprüche,
   **dadurch gekennzeichnet,**
   **dass** als einer der Parameter des Transformators die Hysteresekurve des Transformators gemessen wird, wobei hierzu als Prüfsignal ein periodisches Signal an sekundärseitige Anschlüsse (S1, S2) des Transformators angelegt wird und die sich daraufhin an den sekundärseitigen Anschlüssen (S1, S2) einstellenden Strom- und Spannungswerte gemessen werden, um daraus sowie in Abhängigkeit von dem Wirbelstromwiderstand (Reddy) des Transformators den Spannungs- und Stromverlauf (Uc, $I_L$) an der Hauptinduktivität des Transformators zur Ermittlung der Hysteresekurve abzuleiten.

10. Verfahren nach Anspruch 9,
    **dadurch gekennzeichnet,**
    **dass** die Spannung Uc und der Strom $I_L$ an der Hauptinduktivität des Transformators aus der an den sekundärseitigen Anschlüssen (S1, S2) des Transformators gemessenen Spannung $U_{CT}$, dem an den sekundärseitigen Anschlüssen (S1, S2) gemessenen Strom $I_{CT}$, dem Widerstand $R_{CT}$ der Sekundärwicklung des Transformators und dem Wirbelstromwiderstand Reddy wie folgt abgeleitet werden:

$$Uc = U_{CT} - R_{CT} \cdot I_{CT}$$

$$I_L = I_{CT} - \frac{Uc}{\text{Re}ddy}.$$

11. Verfahren nach einem der vorhergehenden Ansprüche,
    **dadurch gekennzeichnet,**
    **dass** mit Hilfe des Simulationsmodells das Verhalten des Transformators bei Betrieb mit einer von der Frequenz des Prüfsignals abweichenden Frequenz und einer beliebigen sekundärseitigen Last (Zb) ermittelt wird.

**12.** Verfahren nach Anspruch 11,
**dadurch gekennzeichnet,**
**dass** als Parameter des Transformators der Widerstand $R_{CT}$ der Sekundärwicklung des Transformators, der Wirbelstromwiderstand Reddy des Transformators und die Hysteresekurve, welche den Verlauf der Spannung Uc und des Stroms $I_L$ an der Hauptinduktivität des Transformators angibt, gemessen werden,
**dass** der zeitliche Verlauf des verketteten Flusses des Transformators in Abhängigkeit von der Frequenz bestimmt wird, um davon abhängig die Spannung Uc an der Hauptinduktivität des Transformators abzuleiten und in Abhängigkeit davon den entsprechenden Strom $I_L$ an der Hauptinduktivität des Transformators über die gemessene Hysteresekurve zu bestimmen, und
**dass** der über sekundärseitige Anschlüsse (S1, S2) des Transformators fließende Strom $I_{CT}$ und die an den sekundärseitigen Anschlüssen (S1, S2) auftretende Spannung $U_{CT}$ für die vorgegebene Frequenz anschließend wie folgt bestimmt werden:

$$I_{CT} = I_L + \frac{Uc}{\mathrm{Re}ddy}$$

$$U_{CT} = Uc + I_{CT} \cdot R_{CT}.$$

**13.** Verfahren nach einem der vorhergehenden Ansprüche,
**dadurch gekennzeichnet,**
**dass** als Prüfsignal ein nicht-sinusförmiges Prüfsignal verwendet wird.

**14.** Verfahren nach Anspruch 13,
**dadurch gekennzeichnet,**
**dass** als Prüfsignal ein Rechtecksignal verwendet wird.

**15.** Testvorrichtung (1) zum Testen eines Transformators,
mit einer Prüfsignalquelle (2) zum Anlegen eines Prüfsignals an den Transformator,
mit einer Messeinrichtung (4) zum Messen mehrerer Parameter des Transformators bei an dem Transformator angelegtem Prüfsignal, und
mit einer Auswertungseinrichtung (5) zum Auswerten der mit dem Prüfsignal gemessenen Parameter und zum Ableiten eines Simulationsmodells daraus, welches das Übertragungsverhalten des Transformators bei unterschiedlichen Frequenzen simuliert, um mit Hilfe des Simulationsmodells das Übertragungsverhalten des Transformators bei Betrieb mit einer von der Frequenz des Prüfsignals abweichenden Frequenz zu ermitteln, **dadurch gekennzeichnet,**
**dass** die Testvorrichtung mittel derart aufweist, dass als einer der Parameter des Transformators der Wirbelstromwiderstand (Reddy) des Transformators gemessen wird, wobei hierzu mehrere Messungen durch Anlegen eines periodischen Prüfsignals mit jeweils unterschiedlicher Frequenz an sekundärseitige Anschlüsse (S1, S2) des Transformators durchgeführt werden, und wobei die bei den einzelnen Messungen von dem Transformator sekundärseitig aufgenommene Leistung ermittelt wird, um daraus den Wirbelstromwiderstand (Reddy) abzuleiten.

**16.** Testvorrichtung nach Anspruch 15,
**dadurch gekennzeichnet,**
**dass** die Messeinrichtung (4) und die Auswertungseinrichtung (5) in einer Steuereinheit (3), welche in Form eines Controllers und/oder Computers und/oder digitalen Signalprozessors ausgestaltet ist, integriert sind.

**17.** Testvorrichtung nach Anspruch 15 oder 16,
**dadurch gekennzeichnet,**
**dass** die Testvorrichtung mindestens einen mit sekundärseitigen Anschlüssen (S1, S2) des Transformators zu verbindenden Prüfsignalausgang zum Anlegen des Prüfsignals an die sekundärseitigen Anschlüsse (S1, S2) aufweist, und
**dass** die Testvorrichtung mehrere mit den sekundärseitigen Anschlüssen (S1, S2) zu verbindende Messeingänge zum Messen der Parameter des Transformators aufweist.

**18.** Testvorrichtung nach einem der Ansprüche 15-17,

**dadurch gekennzeichnet,**
**dass** die Testvorrichtung in ein tragbares Gerät integriert ist.

**19.** Testvorrichtung nach einem der Ansprüche 15-18,
**dadurch gekennzeichnet,**
**dass** die Testvorrichtung Speichermittel (6) zum Speichern der gemessenen Parameter des Transformators und/oder des Simulationsmodells des Transformators und/oder von Informationen, welche das Übertragungsverhalten des Transformators bei dem Betrieb mit der von der Frequenz des Prüfsignals abweichenden Frequenz beschreiben, aufweist.

**20.** Testvorrichtung nach einem der Ansprüche 15-19,
**dadurch gekennzeichnet,**
**dass** die Testvorrichtung eine Schnittstelle (7) zur Übertragung der gemessenen Parameter des Transformators und/oder des Simulationsmodells des Transformators und/oder von Informationen, welche das Übertragungsverhalten des Transformators bei dem Betrieb mit der von der Frequenz des Prüfsignals abweichenden Frequenz beschreiben, an ein externes Gerät und/oder zum Empfang externer Steuersignale zur automatischen Steuerung des von der Testvorrichtung realisierten Testablaufs aufweist.

**21.** Testvorrichtung nach einem der Ansprüche 15-20,
**dadurch gekennzeichnet,**
**dass** die Testvorrichtung Mittel zur Durchführung des Verfahrens nach einem der Ansprüche 1-14 aufweist.

**Claims**

**1.** Method for testing a transformer,
wherein a test signal with a particular frequency is applied to the transformer for testing the transformer,
wherein a number of parameters of the transformer are measured by means of the test signal,
wherein from the parameters measured by means of the test signal, a simulation model is derived which simulates the transfer behaviour of the transformer at different frequencies, and
wherein the transfer behaviour of the transformer when it is operated at a frequency deviating from the frequency of the test signal is determined with the aid of the simulation model,
**characterized in that** the eddy current resistance (Reddy) of the transformer is measured as one of the parameters of the transformer, for which purpose a number of measurements are performed by applying a periodic test signal with in each case a different frequency to connections (S1, S2) on the secondary of the transformer, and the power absorbed by the secondary of the transformer during the individual measurements is determined in order to derive from this the eddy current resistance (Reddy).

**2.** Method according to Claim 1, **characterized in that** the frequency of the test signal is lower than the nominal frequency of the transformer, and **in that** the transfer behaviour of the transformer when it is operated at the nominal frequency is determined with the aid of the simulation model.

**3.** Method according to Claim 1 or 2, **characterized in that** the test signal is applied to connections (S1, S2) on the secondary of the transformer, and **in that** the parameters of the transformer are measured at the connections (S1, S2) on the secondary of the transformer.

**4.** Method according to any one of the preceding claims, **characterized in that** the test signal is applied to the transformer with a voltage which is lower than the voltage required for measuring the knee point when the transformer is operated at the nominal frequency.

**5.** Method according to any one of the preceding claims, **characterized in that** the test signal is used for measuring a number of frequency- and/or voltage-dependent parameters of the transformer in order to derive from these the simulation model.

**6.** Method according to one of the preceding claims,
**characterized in that** the resistance ($R_{CT}$) of the secondary winding of the transformer is measured as one of the parameters, for which purpose a direct-current signal is applied as test signal to connections (S1, S2) on the secondary of the transformer and the voltage ($U_{CT}$) produced across the connections (S1, S2) on the secondary of the transformer and the current ($I_{CT}$) flowing through the connections (S1, S2) on the secondary of the transformer are measured in order to derive from these the resistance ($R_{CT}$) of the secondary winding.

7.  Method according to any one of the preceding claims, **characterized in that**, to measure the eddy current resistance (Reddy) of the transformer, two measurements are performed at two different frequencies $f_1$ and $f_2$ and the power $P_1$ and $P_2$ absorbed by the transformer during the two measurements is measured, the following holding true:

$$P_1 = \alpha \cdot f_1 + \beta \cdot f_1^2$$

$$P_2 = \alpha \cdot f_2 + \beta \cdot f_2^2$$

where the factors $\alpha$ and $\beta$ are determined as a function of the frequencies $f_1$ and $f_2$ and on the powers $P_1$ and $P_2$, as follows:

$$\alpha = \frac{P_1 \cdot f_2^2 - P_2 \cdot f_1^2}{f_1 \cdot f_2 \cdot (f_2 - f_1)}$$

$$\beta = \frac{P_2 \cdot f_1 - P_1 \cdot f_2}{f_1 \cdot f_2 \cdot (f_2 - f_1)}$$

in order to derive from these the eddy current resistance (Reddy).

8.  Method according to Claim 7, **characterized in that** the eddy current resistance Reddy is determined via the following relation:

$$Reddy = \frac{Uc_{rms1}^2}{\beta \cdot f_1^2} = \frac{Uc_{rms2}^2}{\beta \cdot f_2^2}$$

where $Uc_{rms1}$ designates the rms value of the voltage at the main inductance of the transformer during the measurement with the frequency $f_1$ and $Uc_{rms2}$ designates the rms value of the voltage at the main inductance of the transformer during the measurement with the frequency $f_2$.

9.  Method according to any one of the preceding claims, **characterized in that** the hysteresis curve of the transformer is measured as one of the parameters of the transformer, for which purpose a periodic signal is applied as test signal to connections (S1, S2) on the secondary of the transformer and the current and voltage values then occurring at the connections (S1, S2) on the secondary are measured in order to derive from these, and as a function of the eddy current resistance (Reddy) of the transformer, the voltage and current variation ($Uc$, $I_L$) on the main inductance of the transformer in order to determine the hysteresis curve.

10. Method according to Claim 9, **characterized in that** the voltage $Uc$ and the current $I_L$ on the main inductance of the transformer are derived from the voltage $U_{CT}$ measured at the connections (S1, S2) on the secondary of the transformer, the current $I_{CT}$ measured at the connections (S1, S2) on the secondary, the resistance $R_{CT}$ of the secondary winding of the transformer and the eddy current resistance Reddy, as follows:

$$Uc = U_{CT} - R_{CT} \cdot I_{CT}$$

$$I_L = I_{CT} - \frac{Uc}{Reddy}.$$

11. Method according to any one of the preceding claims, **characterized in that** the behaviour of the transformer during operation with a frequency deviating from the frequency of the test signal and an arbitrary load (Zb) on the secondary is determined with the aid of the simulation model.

**12.** Method according to Claim 11, **characterized in that** the resistance $R_{CT}$ of the secondary winding of the transformer, the eddy current resistance Reddy of the transformer and the hysteresis curve, which specifies the variation of the voltage Uc on and of the current $I_L$ in the main inductance of the transformer, are measured as parameters of the transformer, **in that** the variation of the interlinked flux of the transformer with time is determined as a function of the frequency in order to derive as a function of this the voltage Uc on the main inductance of the transformer and to determine as a function of the corresponding current $I_L$ in the main inductance of the transformer from the measured hysteresis curve, and **in that** the current $I_{CT}$ flowing via connections (S1, S2) on the secondary of the transformer and the voltage $U_{CT}$ occurring at the connections (S1, S2) on the secondary are then determined for the predetermined frequency, as follows:

$$I_{CT} = IL + \frac{Uc}{Reddy}$$

$$U_{CT} = Uc + I_{CT} \cdot R_{CT}.$$

**13.** Method according to any one of the preceding claims, **characterized in that** a non sinusoidal test signal is used as the test signal.

**14.** Method according to Claim 13, **characterized in that** a square-wave signal is used as the test signal.

**15.** Test device (1) for testing a transformer,
with a test signal source (2) for applying a test signal to the transformer,
with a measuring device (4) for measuring a number of parameters of the transformer with the test signal applied to the transformer, and
with an evaluation device (5) for evaluating the parameters measured by means of the test signal and for deriving from these a simulation model which simulates the transfer behaviour of the transformer at different frequencies in order to determine the transfer behaviour of the transformer during operation with a frequency deviating from the frequency of the test signal with the aid of the simulation model,
**characterized in that** the test device comprises means such that the eddy current resistance (Reddy) of the transformer is measured as one of the parameters of the transformer, for which purpose a number of measurements are performed by applying a periodic test signal with in each case a different frequency to connections (S1, S2) on the secondary of the transformer, and the power absorbed by the secondary of the transformer during the individual measurements is determined in order to derive from this the eddy current resistance (Reddy).

**16.** Test device according to Claim 15, **characterized in that** the measuring device (4) and the evaluation device (5) are integrated in a control unit (3) which is constructed in the form of a controller and/or computer and/or digital signal processor.

**17.** Test device according to Claim 15 or 16, **characterized in that** the test device has at least one test signal output, to be connected to connections (S1, S2) on the secondary of the transformer, for applying the test signal to the connections (S1, S2) on the secondary, and **in that** the test device has a number of test inputs, to be connected to the connections (S1, S2) on the secondary, for measuring the parameters of the transformer.

**18.** Test device according to any one of Claims 15-17, **characterized in that** the test device is integrated into a portable instrument.

**19.** Test device according to any one of Claims 15-18, **characterized in that** the test device has storage means (6) for storing the measured parameters of the transformer and/or the simulation model of the transformer and/or information which describes the transfer behaviour of the transformer during operation at the frequency deviating from the frequency of the test signal.

**20.** Test device according to any one of Claims 15-19, **characterized in that** the test device has an interface (7) for transmitting the measured parameters of the transformer and/or the simulation model of the transformer and/or information which describes the transfer behaviour of the transformer during operation at the frequency deviating from the frequency of the test signal, to an external device, and/or for receiving external control signals for the automatic control of the test sequence implemented by the test device.

**21.** Test device according to any one of Claims 15-20, **characterized in that** the test device comprises means for carrying out the method according to any one of Claims 1-14.

**Revendications**

**1.** Procédé pour tester un transformateur,
un signal de contrôle d'une fréquence déterminée étant appliqué sur le transformateur pour tester le transformateur,
plusieurs paramètres du transformateur étant mesurés avec le signal de contrôle,
un modèle de simulation qui simule le comportement de transmission du transformateur à différentes fréquences étant dérivé des paramètres mesurés avec le signal de contrôle et
le comportement de transmission du transformateur lors du fonctionnement à une fréquence divergeant de la fréquence du signal de contrôle étant déterminé à l'aide du modèle de simulation,
**caractérisé en ce que**
la résistance au courant de Foucault (Reddy) du transformateur est un des paramètres du transformateur mesurés, plusieurs mesures étant effectuées pour cela par application d'un signal de contrôle périodique de fréquence respectivement différente sur des raccords du côté secondaire (S1, S2) du transformateur et la puissance absorbée par le transformateur sur son côté secondaire lors des différentes mesures étant déterminée pour en dériver la résistance au courant de Foucault (Reddy).

**2.** Procédé selon la revendication 1,
**caractérisé en ce que**
la fréquence du signal de contrôle est inférieure à la fréquence nominale du transformateur et **en ce que**,
à l'aide du modèle de simulation, le comportement de transmission du transformateur lors du fonctionnement à la fréquence nominale est déterminé.

**3.** Procédé selon la revendication 1 ou 2,
**caractérisé en ce que**
le signal de contrôle est appliqué sur des raccords du côté secondaire (S1, S2) du transformateur et **en ce que**
les paramètres du transformateur sont mesurés sur les raccords du côté secondaire (S1, S2) du transformateur.

**4.** Procédé selon une des revendications précédentes,
**caractérisé en ce que**
le signal de contrôle est appliqué sur le transformateur à une tension inférieure à la tension nécessaire lors d'un fonctionnement du transformateur à la fréquence nominale pour mesurer le coude.

**5.** Procédé selon une des revendications précédentes,
**caractérisé en ce que**
avec le signal de contrôle plusieurs paramètres du transformateur dépendants de la fréquence et/ou de la tension sont mesurés pour en dériver le modèle de simulation.

**6.** Procédé selon une des revendications précédentes,
**caractérisé en ce que**
un des paramètres mesurés est la résistance ($R_{CT}$) de l'enroulement secondaire du transformateur, un signal de courant continu étant à cet effet appliqué comme signal de contrôle sur des prises du côté secondaire (S1, S2) du transformateur et la tension ($U_{CT}$) générée sur les prises du côté secondaire (S1, S2) du transformateur et le courant ($I_{CT}$) passant par les prises du côté secondaire (S1, S2) du transformateur étant mesurés, afin d'en dériver la résistance ($R_{CT}$) de l'enroulement secondaire.

**7.** Procédé selon une des revendications précédentes,
**caractérisé en ce que**
pour mesurer la résistance au courant de Foucault (Reddy) du transformateur deux mesures sont effectuées à deux fréquences différentes $f_1$ et $f_2$ et **en ce que** la puissance $P_1$ et $P_2$ absorbée par le transformateur lors des deux mesures est mesurée, ce qui suit étant valable :

$$P_1 = \alpha \cdot f_1 + \beta \cdot f_1^2$$

$$P_2 = \alpha \cdot f_2 + \beta \cdot f_2^2,$$

les facteurs $\alpha$ et $\beta$ étant déterminés comme suit en fonction des fréquences $f_1$ et $f_2$ ainsi que des puissances $P_1$ et $P_2$ :

$$\alpha = \frac{P_1 \cdot f_2^2 - P_2 \cdot f_1^2}{f_1 \cdot f_2 \cdot (f_2 - f_1)}$$

$$\beta = \frac{P_2 \cdot f_1 - P_1 \cdot f_2}{f_1 \cdot f_2 \cdot (f_2 - f_1)},$$

afin d'en dériver la résistance au courant de Foucault (Reddy).

**8.** Procédé selon la revendication 7,
**caractérisé en ce que**
la résistance au courant de Foucault Reddy est déterminée via la relation suivante :

$$\text{Reddy} = \frac{Uc_{eff1}^2}{\beta \cdot f_1^2} = \frac{Uc_{eff2}^2}{\beta \cdot f_2^2},$$

$U_{Ceff1}$ déterminant la valeur effective de la tension sur l'inductance principale du transformateur lors de la mesure à la fréquence $f_1$ et $U_{Ceff2}$ la valeur effective de la tension sur l'inductance principale du transformateur lors de la mesure à la fréquence $f_2$.

**9.** Procédé selon une des revendications précédentes,
**caractérisé en ce que**
la courbe d'hystérésis du transformateur est un des paramètres du transformateur mesurés, un signal périodique sur des prises côté secondaire (S1, S2) du transformateur étant appliqué comme signal de contrôle et les valeurs de courant et de tension en résultant sur les prises côté secondaire (S1, S2) étant mesurées, afin d'en dériver, également en fonction de la résistance au courant de Foucault (Reddy) du transformateur l'évolution de la tension et du courant ($U_C$, $I_L$) sur l'inductance principale du transformateur pour déterminer la courbe d'hystérésis.

**10.** Procédé selon la revendication 9,
**caractérisé en ce que**
la tension $U_C$ et le courant $U_L$ sur l'inductance principale du transformateur sont dérivées de la tension $U_{CT}$ mesurée sur les prises côté secondaire (S1, S2) du transformateur, du courant $I_{CT}$ mesuré sur les prises côté secondaire (S1, S2), de la résistance $R_{CT}$ de l'enroulement secondaire du transformateur et de la résistance au courant de Foucault Reddy comme suit :

$$Uc = U_{CT} - R_{CT} - I_{CT}$$

$$I_L = I_{CT} \frac{Uc}{\text{Re}ddy}.$$

**11.** Procédé selon une des revendications précédentes,
**caractérisé en ce que**,
à l'aide du modèle de simulation le comportement du transformateur lors du fonctionnement à une fréquence divergeant de la fréquence du signal de contrôle et avec une charge côté secondaire (Zb) au choix est déterminé.

**12.** Procédé selon la revendication 11,

**caractérisé en ce que**

les paramètres du transformateur mesurés sont la résistance $R_{CT}$ de l'enroulement secondaire du transformateur, la résistance au courant de Foucault Reddy du transformateur et la courbe d'hystérésis qui indique l'évolution de la tension $U_C$ et du courant $I_L$ sur l'inductance principale du transformateur,

**en ce que** l'évolution dans le temps du flux interconnecté du transformateur est déterminé en fonction de la fréquence, afin d'en dériver la tension $U_C$ sur l'inductance principale du transformateur en conséquence et de déterminer en conséquence le courant correspondant $I_L$ sur l'inductance principale du transformateur par le biais de la courbe d'hystérésis mesurée, et **en ce que** le courant $I_{CT}$ qui travers les raccords côté secondaire (S1, S2) du transformateur et la tension $U_{CT}$ générée sur les raccords côté secondaire (S1, S2) sont ensuite déterminés comme suit pour la fréquence donnée :

$$I_{CT} = I_L + \frac{Uc}{\mathrm{Re}ddy}$$

$$U_{CT} = Uc + I_{CT} \cdot R_{CT}.$$

**13.** Procédé selon une des revendications précédentes,

**caractérisé en ce que**

un signal de contrôle non sinusoïdal est utilisé comme signal de contrôle.

**14.** Procédé selon la revendication 13,

**caractérisé en ce que**

un signal rectangulaire est utilisé comme signal de contrôle.

**15.** Dispositif de test (1) pour tester un transformateur,

avec une source de signaux de contrôle (2) pour appliquer un signal de contrôle sur le transformateur,

avec un dispositif de mesure (4) pour mesurer plusieurs paramètres du transformateur alors que le signal de contrôle est appliqué sur le transformateur et

avec un dispositif d'analyse (5) pour analyser des paramètres mesurés avec le signal de contrôle et pour en dériver un modèle de simulation qui simule le comportement de transmission du transformateur à différentes fréquences, afin de déterminer à l'aide du modèle de simulation le comportement de transmission du transformateur lors du fonctionnement à une fréquence divergeant de la fréquence du signal de contrôle,

**caractérisé en ce que** le dispositif de test comporte des moyens tels que la résistance au courant de Foucault (Reddy) est un des paramètres du transformateur mesurés, plusieurs mesures étant effectuées par application d'un signal de contrôle périodique à une fréquence respectivement différente sur des raccords côté secondaire (S1, S2) du transformateur et la puissance absorbée par le transformateur côté secondaire lors des différentes mesures étant déterminée afin d'en dériver la résistance au courant de Foucault (Reddy).

**16.** Dispositif de test selon la revendication 15,

**caractérisé en ce que**

le dispositif de mesure (4) et le dispositif d'analyse (5) sont intégrés dans une unité de commande (3) qui est configurée sous la forme d'un contrôleur et/ou d'un ordinateur et/ou d'un processeur de signaux numérique.

**17.** Dispositif de test selon la revendication 15 ou 16,

**caractérisé en ce que** le dispositif de test comporte au moins une sortie de signal de contrôle à relier avec des raccords côté secondaire (S1, S2) du transformateur pour appliquer le signal de contrôle sur les raccords côté secondaire (S1, S2) et

**en ce que** le dispositif de test comporte plusieurs entrées de mesure à relier avec les raccords côté secondaire (S1, S2) pour mesurer les paramètres du transformateur.

**18.** Dispositif de test selon une des revendications 15 à 17,

**caractérisé en ce que**

le dispositif de test est intégré dans un appareil portable.

**19.** Dispositif de test selon une des revendications 15 à 18,

**caractérisé en ce que**

le dispositif de test comporte des supports de mémorisation (6) pour mémoriser les paramètres mesurés du transformateur et/ou du modèle de simulation et/ou des informations qui décrivent le comportement de transmission du transformateur lors du fonctionnement à la fréquence divergeant de la fréquence du signal de contrôle.

20. Dispositif de test selon une des revendications 15 à 19,
   **caractérisé en ce que** le dispositif de test comporte une interface (7) pour la transmission des paramètres mesurés et/ou du modèle de simulation du transformateur et/ou d'informations qui décrivent le comportement de transmission du transformateur lors du fonctionnement avec la fréquence divergeant de la fréquence du signal de contrôle à un appareil externe et/ou pour la réception de signaux de commande externes pour la commande automatique du déroulement du test réalisé par le dispositif de test.

21. Dispositif de test selon une des revendications 15 à 20,
   **caractérisé en ce que**
   le dispositif de test comporte des moyens de réalisation du procédé conformément à une des revendications 1 à 14.